(19) Europäisches Patentamt
European Patent Office
Office européen des brevets

(11) **EP 4 647 776 B1**

(12) **EUROPEAN PATENT SPECIFICATION**

(45) Date of publication and mention
of the grant of the patent:
**15.04.2026 Bulletin 2026/16**

(21) Application number: 24190019.0

(22) Date of filing: **22.07.2024**

(51) International Patent Classification (IPC):
**G01R 1/20** *(2006.01)*      **G01R 1/28** *(2006.01)*
**G01R 35/00** *(2006.01)*

(52) Cooperative Patent Classification (CPC):
**G01R 1/203; G01R 1/28; G01R 35/007**

(54) **MEASUREMENT SYSTEM FOR MEASURING HIGH VALUE CURRENTS WITH WIDE FREQUENCY SPECTRUM AND METHOD OF SUCH MEASUREMENT**

MESSSYSTEM ZUR MESSUNG VON HOCHSTROMWERTEN MIT BREITEM FREQUENZSPEKTRUM UND VERFAHREN ZUR MESSUNG

SYSTÈME DE MESURE POUR MESURER DES COURANTS DE GRANDE VALEUR AVEC UN LARGE SPECTRE DE FRÉQUENCES ET PROCÉDÉ DE MESURE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **10.05.2024 PL 44852524**

(43) Date of publication of application:
**12.11.2025 Bulletin 2025/46**

(73) Proprietor: **Akademia Gorniczo-Hutnicza im. Stanislawa
Staszica w Krakowie
30-059 Krakow (PL)**

(72) Inventors:
• **NABIELEC, Jerzy**
  **31-201 Kraków (PL)**
• **MARSZALEK, Zbigniew**
  **31-878 Kraków (PL)**

(74) Representative: **Wlasienko, Jozef et al
Polservice
Kancelaria Rzecznikow
Patentowych sp. z o.o.
Bobrowiecka 8
00-728 Warszawa (PL)**

(56) References cited:
EP-B1- 3 417 305      US-A1- 2020 116 764
US-A1- 2022 413 017

# Description

## FIELD OF THE INVENTION

The invention relates to a measurement system for measuring high value currents with a wide frequency spectrum under real operating conditions, in particular for measuring current intensity by means of an adaptive shunt circuit with computationally corrected frequency characteristics by using methods for the self-calibration of the measurement path, and a method of such measurement.

The solution according to the invention relates to the field of electrical power engineering and electrical engineering that combines elements of electronics and signal analysis using digital signal processing methods. The invention basically relates to measurement systems, in particular the measurement of current intensity.

## BACKGROUND OF THE INVENTION

Modern electrical power devices designed for the generation, transformation, distribution and utilization of electrical energy, such inverters, electric drives, transformers, electric apparatus, safety apparatus, electric heating engineering, etc. require accurate measurement of the instantaneous values of high-frequency high value currents, and not necessarily of their rms (root mean square) value.

Currently used methods and instruments for measuring high-value current are calibrated for direct currents or for currents with the power-line frequency in the order of 50 Hz. Modern electrical power devices generate high value currents with a very wide frequency spectrum in the order of fractions of Hz to hundreds of kHz, which consequently leads, with currently used measurement methods and measurement systems, to obtaining incorrect measurement results.

## DESCRIPTION OF THE PRIOR ART

In the prior art, there are known measurement methods and systems that were developed many years ago to measure direct currents or low-frequency currents in the order of 50 Hz. Nevertheless, if the measured current has a rich spectrum of harmonics, i.e. non-sinusoidal, distorted currents - not having a sinusoidal shape, and currently such currents are frequently present in power electronic systems, e.g. in inverter systems, induction heating systems, magnetic bearing control systems, magnetic levitation, energy-efficient lighting, in arc furnaces or in modern energy storages, modern SMART GRID systems, then such devices require the measurement and diagnosis of distorted currents with a spectrum even up to 100 kHz, subharmonic and interharmonic currents. An additional challenge with regard to the control systems of magnetic or rotating bearings or magnetic energy storages is the necessity to measure the current in real time.

In the prior art, there are known measurement systems using a Rogowski coil where the basic measurement signal used in this method is not the current itself, but the derivative of the measured current. Such a system must have additional circuits performing the integral in an analogue manner to obtain the necessary measurement information. An ideal integral circuit is not technically feasible. For this reason, the result of measurement is a certain approximation for a rather narrow frequency spectrum, and thus this case does not involve a wide frequency spectrum which is of interest to the present inventors, as in the solution according to the invention.

Generally, transducers that have been offered so far do not meet such high measurement requirements. For example, for LEM-type transducers, the manufacturer provides very accurate amplitude and frequency characteristics in the catalogues, whereas he does not publish phase and frequency characteristics, which are unacceptable (strongly non-linear) when measuring distorted currents. The negative effect of the unfavourable phase and frequency characteristics is that the shape of the recorded current measurement result is completely different with respect to its actual waveform. Therefore, the LEM-type transducer is only suitable for the measurements of the rms (root mean square) value, whereas it is not suitable for mapping the shape of distorted waveforms.

In the prior art, there are also known special resistors enabling the measurement of high values of the current, referred to as current shunts, used for the measurement of direct and alternating current depending on the meter used. Shunts of this type can be internal or external. An internal shunt is built into a meter used to measure smaller currents, in the order of several, a dozen or so amperes, whereas an external shunt is used to measure currents in the order of more than ten amperes, e.g. 15A, to several thousand.

Prior art document US2022/413017 exemplifies the commonly known principle of using a low value, low precision shunt resistor carrying most of the current in parallel with a higher value, higher precision resistor that can be switched in/out of the circuit in order to calibrate the system, i.e., two measurements are made, with and without the precision resistor switched in.

Furthermore, there are known WSM-type measurement shunts designed for precise measurement of direct and alternating current pulses, e.g. in industrial drives, pulsed welders and plasma physics apparatus. Moreover, they are used in short-circuit test devices, measurements of inrush currents of engines, etc. Compared with other methods, WSM-type measurement shunts have a wide bandwidth. They do not use auxiliary electronics and do not require auxiliary power. Their high electromagnetic compatibility and robust design enable trouble-free operation in harsh environments. However, they are susceptible to temperature effects on the measurement result. Additionally, they are made of a material (for example, manganin) that is very sensitive to thermal overloads. If the shunt is overheated once with a too high current, it loses its measuring properties irreversibly. The proposed solution according to the invention makes it possible to eliminate this disadvantage by using, only in the low-current reference part, materials resistant to large temperature changes. At the same time, due to the use of a system with variable structure (carried out using a switch) and an operational algorithm, the said disadvantage is eliminated. As a result, the entire measurement system and the method according to the invention is resistant to the influence of temperature, although its high-current components are susceptible, event strongly, to the influence of temperature.

The above-described prior-art solution and, more broadly, solutions concerning measurements methods and systems, are generally sensitive to environmental conditions, i.e. their parameters depend on humidity, temperature, dustiness, etc. Therefore, they require periodic verification, i.e. calibration. Calibration is understood, as a standardization and in relation to measurement instruments, as all activities establishing the relationship between the values of the measured quantity indicated by the measurement instrument and the corresponding values of physical quantities carried out by the standard of the measurement unit, together with indicating uncertainty of the measurement.

Moreover, calibration should be carried out in specialist, accredited laboratories. In Poland, it is the Central Office of Measures [*G łówny Urząd Miar - GUM*]. This often involves stopping the technological process, disassembling and transporting the apparatus to the GUM laboratory. Measurement instruments subject to verification are tested under laboratory conditions, which are usually diametrically different from normal operating conditions on a process line. For example, measurement instruments are tested in air-conditioned laboratories, whereas they usually operate in the temperature range from -30°C to +80°C (in full sunlight) and when installed on power lines in an open area. Furthermore, this verification is only performed for a few selected frequencies, which is a major limitation with this type of procedure.

Therefore, the intention of this invention is to overcome these drawbacks of the prior art, and more specifically to overcome certain limitations in this respect and thus to enable an accurate measurement of high value currents with a wide frequency spectrum by using self-calibration at the place and conditions of operation of the measurement instrument, in the presented case of a meter, and not in a laboratory, as is the case with the prior art described above.

## SUMMARY OF THE INVENTION

The object of the invention is to develop a totally new solution in the form a measurement system for measuring high value currents with a wide frequency spectrum, in particular for measuring current intensity by means of an adaptive shunt circuit with computationally corrected frequency characteristics, using methods for the self-calibration of the measurement path under real operating conditions thereof, and a method for such measurement.

The proposed method and system is intended to increase the accuracy of the measurement of instantaneous values of high value currents with a wide frequency spectrum, in particular the measurement of current intensity in real time at the place of operation thereof. The basic assumption is that operating conditions, e.g. thermal, do not change very quickly; therefore the verification period of the measurement parameters of a measurement instrument, in the process of self-calibration, in the order of 1 s, is sufficient to detect and correct the trend of small changes in the parameters of the measurement system, e.g. the measurement constant. For objects with other dynamic parameters, a period other than 1s can be selected.

In the light of the above, the purpose of the invention is therefore to enable calibration of the measurement path at the place of its operation and without interrupting its operation, by adapting the parameters of the measurement instrument to real operating conditions. It should be emphasized here that it is not the physical parameters of devices used in the measurement system that are subject to correction, but the correction of the measurement result is performed by calculations after prior identification of the parameters of the measurement devices.

The essence of the invention in defined in the presented case by a measurement system for measuring high value currents with a wide frequency spectrum under real operating conditions according to claim 1. The dependent claim 2 relates to an embodiment of the invention according to claim 1. The essence of the invention is further defined by a method for measuring high value currents with a wide frequency spectrum under real operating conditions according to claim 3. The dependent claim 4 relates to an embodiment of the invention according to claim 3.

To achieve the above purposes, according to one of the aspects of the invention, the invention provides a measurement system for measuring high value currents with a wide frequency spectrum under real operating conditions, which system comprises an electrical energy source in the form of a DC or AC voltage source connected in series to a measurement instrument designed to measure the correct or accurate value of a selected frequency component of current $\gamma I$ in the circuit of an electrical energy receiver, wherein the measurement instrument indicating an inaccurate value $I$ is subject to the process of self-calibration, characterized in that

it has a built-in calibration circuit connected in series to the flow path of current $\gamma I$, which the calibration circuit is designed to verify and periodically determine the measurement properties of the measurement instrument, that is coefficient $\gamma$, at the place and time of operation of the measurement instrument, comprises parallel connection of three branches: the first branch comprising a measurement instrument of auxiliary current $i$ and the second branch in the form of a normal resistor or a shunt using a pair of voltage terminals of the shunt, and also the third branch using a pair of current terminals of the shunt, comprising a switch connected in series to a measurement instrument of reference current $j$, wherein the individual subassemblies of the calibration circuit are integrated with one another and are digitally controlled by means of a digital synchronization and control system which simultaneously constitutes an interface for the operator.

Preferably, the said measurement instrument or the measurement instrument of the first branch or the normal resistor together with the shunt of the second branch is made using a current transformer, a LEM current transducer or a Rogowski coil.

According to one aspect of the invention, the invention also provides a method for measuring high value currents with a wide frequency spectrum under real operating conditions which consists in measuring the correct or accurate value of a selected frequency component of current $\gamma I$ in the circuit of the electrical energy receiver by means of a measurement instrument while this measurement instrument gives an inaccurate value $I$, characterized in that

the measurement instrument is subjected to the process of self-calibration for each detected frequency in the recorded current waveforms by determining the value of coefficient $\gamma$ defined as a complex number individually for each detected frequency of the correcting results of the measurement of the frequency component from the full spectrum of technological current $I$ supplied by the measurement instrument, using the calibration circuit connected in series to the flow path of current $\gamma I$, by means of the following relation:

$$\gamma = \frac{j i_1}{I_2 i_1 - I_1 i_2}$$

where:

$I_1$ - is the value of technological current measured by the measurement instrument in the open state of the switch,
$I_2$ - is the value of technological current measured by the measurement instrument in the closed state of the switch,
$i_1$ - is the value of auxiliary current measured by the measurement instrument in the open state of the switch
$i_2$ - is the value of auxiliary current measured by the measurement instrument in the closed state of the switch,

$j$ - is the value of reference current measured by the measurement instrument in the closed state of the switch,

wherein the calibration circuit changes its structure cyclically by closing and opening the switch digitally controlled by means of a digital synchronization and control system.

Preferably, the said calibration circuit changes its structure cyclically, preferably within a period of 1s.

The solution provided according to the aspect proposed above enables self-calibration of the measurement path for high value currents at the place of its operation, and not in a laboratory as in the case of the above-described prior art. In the solution according to the invention the self-calibration of the measurement instrument, in the presented case of a meter, i.e. the procedure of periodic verification and updating of coefficients of the measurement system under its real operating conditions, is performed individually for each frequency detected in the recorded current waveform, using Fourier analysis, without interrupting the operating measurement procedure of the technological process. The procedure of self-calibration involves solving equations describing the electrical circuit, for each detected frequency in the recorded current waveforms.

Thus, the process of self-calibration takes into account additional external influences that are not present in the laboratory calibration process. For example, the procedure of self-calibration at the place of operation makes it possible to take into account and eliminate the influence of seasonal or daily temperature changes on the metrological parameters of the measurement path. During laboratory calibration, the values of the measurement path parameters are determined for a predetermined but wide range of temperature changes, but only for a few selected values within this range, which significantly reduces the determination of the actual values of these parameters at the place of operation of the measurement path and reduces the accuracy of the obtained measurement result. For example, during laboratory calibration, the values of current meter parameters are determined for the temperatures 0°C and 50°C, whereas these parameters are not determined for e.g. 38.5°C.

For such a temperature, standardly, according to currently obligatory procedures, the meter parameters are determined by the interpolation of characteristics, usually linear, between the values of 0°C and 50°C, which leads to generating of additional errors. The proposed solution according to the invention makes it possible to determine the parameters of the measurement path for any temperature (e.g. 38.5°C), as well as for any other temperature within the permissible range of temperature changes for a given instrument. Furthermore, using a table of temperature-dependent corrections, obtained during the laboratory calibration at GUM, would require introducing an additional temperature measurement path. The proposed solution does not require temperature measurement.

Similarly, for example, laboratory calibration is performed for the frequencies of 50.00Hz and 50.10Hz. The proposed system according to the invention makes it possible to perform calibration of a measurement instrument for the exemplary frequency of 50.04Hz, detected in the power grid.

Furthermore, self-calibration uses a built-in reference of an electrical value of the measurement instrument located in stabilized thermal conditions, which has a small volume, e.g. a highly stable source of voltage and frequency having dimensions the size of a soapbox. The procedure of self-calibration de facto consists in the verification and periodic determination of the measurement properties of the entire measurement system under real operating conditions.

Additionally, the necessary periodic verification of the accuracy of the applied standard of an electrical value in the form of frequency and voltage is performed without stopping the technological process, by replacing these legalized reference device. Replacing these devices (the previously used one with a new, freshly calibrated one) is no more complicated than changing the batteries in a flashlight. Basically, it is a Plug-and-Play type of operation, i.e. plug in and use, or a procedure referred to as hot reserve.

At this point, it is worth emphasizing that the measurement system according to the invention is provided with a pair of docking stations for the calibration circuit for measuring small currents, which comprises a reference voltage source. One of these docking stations is incorporated into the operating calibration circuit. The other station is empty. In the period preceding the replacement date of the calibration circuit, a new legalized subassembly is placed in the empty docking station. It is simply inserted and a safety flap is closed. The digital synchronization and control system detects the presence of a new device and begins the procedure of preparing it for operation, usually bringing it to a set temperature. When the device is ready and signals this, the digital synchronization and control system independently switches the control signals and reference voltages from the previously used device to the newly placed one. The switching procedure is very short, it takes a few milliseconds and is carried out during the operation period of the system when self-calibration is not performed, i.e. when the switch is open. After successful completion of the replacement, the digital synchronization and control system signalizes to the operator that the subassemblies used so far are ready to be removed. After this message, the operator removes the already inactive device from the docking station and submits it for verification. The docking station used so far remains empty until subsequent replacement of the subassemblies within a set time interval, e.g. 1 year. In the event of an unsuccessful replacement, the system continues to operate with the device used so far and waits for another new device.

Moreover, the solution according to the invention is able to perform the calibration of the measurement path at its place of operation and without interrupting its operation as it adapts itself to the real operating conditions, and thus it is not necessary to disassemble the measurement instrument and transport it to a specialized laboratory and then transport it again to and reassemble it in the target environment from which it was previously disassembled. For example, a shunt used to measure current in the aluminum electrolysis path may have a weight in the order of 100 kg, so a large vehicle and a crane is necessary to transport it, whereas the procedure of self-calibration uses devices that fit easily into a briefcase. In the light of the above, it is an unquestionable advantage that there is no need to install a replacement for the entire measurement instruments for the time required to perform its calibration. It is sufficient to replace a small subassembly.

It should also be emphasized that measurement instruments used to measure high value currents are generally heavy, they have large dimensions and do not fit into a passenger car; therefore their transportation is relatively cumbersome, which has been completely eliminated in the case of the solution according to the invention. For example, it is not necessary to switch off the entire power line to disassemble the measurement path for measuring the current flowing through it. The measurement instruments for measuring small currents used in the solution according to the invention are handy and easy to transport. Moreover, the calibration procedure itself does not interfere with the technological process, which is a great advantage of the solution according to the invention compared to the prior art.

One unexpected feature of the solution according to the invention is the fact that all impedances through which high value (operational/measured) current flows do not need to have a precisely defined value, and a rough estimate of them is sufficient. Also, the values of these impedances can fluctuate under the influence of climatic conditions and aging, but despite that the measurement system according to the invention will operate with expected accuracy for many years.

Another advantage of the proposed solution according to the invention is that it is not necessary to use expensive raw materials to made the high-current circuits of the measurement system according to the invention, e.g. constantan, which is an alloy of 60% copper and 40% nickel characterized by a small influence of its temperature changes on its resistivity, or e.g. manganin, which is an alloy of copper and manganese and nickel, which is characterized by high sensitivity to thermal overload and can be destroyed under the influence of short-circuit currents that occur in power grids.

A further advantage of the claimed solution according to the invention in the form the measurement system for measuring high value currents with a wide frequency spectrum is that it is possible to use shunts having conventional design in the form of a band or rod instead of currently used spatial designs, in the form of a WSM foil shunt in the shape of a pipe made from a thin foil (highly sensitive to thermal overload and mechanical damage) or a sequence of thin rods connected in parallel or a bifilar design, which have been used so far to at least partially eliminate or limit the above indicated defects of these designs.

In the simplest embodiment, it is possible to use, instead of an additional shunt, a high value-current conductor bus by attaching to it a pair of wires forming a parallel branch for the flow of current used in the procedure of self-calibration.

## BRIEF DESCRIPTION OF THE DRAWINGS

The subject matter of the invention is presented in the embodiment with reference to the appended drawings wherein:

FIG. 1 shows an electrical diagram of a prior-art measurement system in three variants: variant a) measuring current by means of milliammeter with internal impedance $q_A$, variant b) measuring voltage by means of a millivoltmeter with internal impedance $q_v$, and variant c) measuring voltage by means of millivoltmeter with infinite internal impedance;

FIG. 2 shows an electrical diagram of the measurement system according to the invention in two embodiments in variant a) with a normal resistor and in variant b) with a shunt;

## DETAILED DESCRIPTION OF THE INVENTION

The subject matter of the invention is described in detail below with reference to the appended figures and embodiments. The invention is not limited only to the detailed embodiments described herein.

In the embodiment presented, the measurement system developed according to the invention is used. An identical system can be used to measure current in an arc furnace or current in a power line as well as in a magnetic bearing and also to measure direct technological current in the process of aluminum electrolysis. It is also easy and inexpensive to measure current conducted through a railway rail in electric traction.

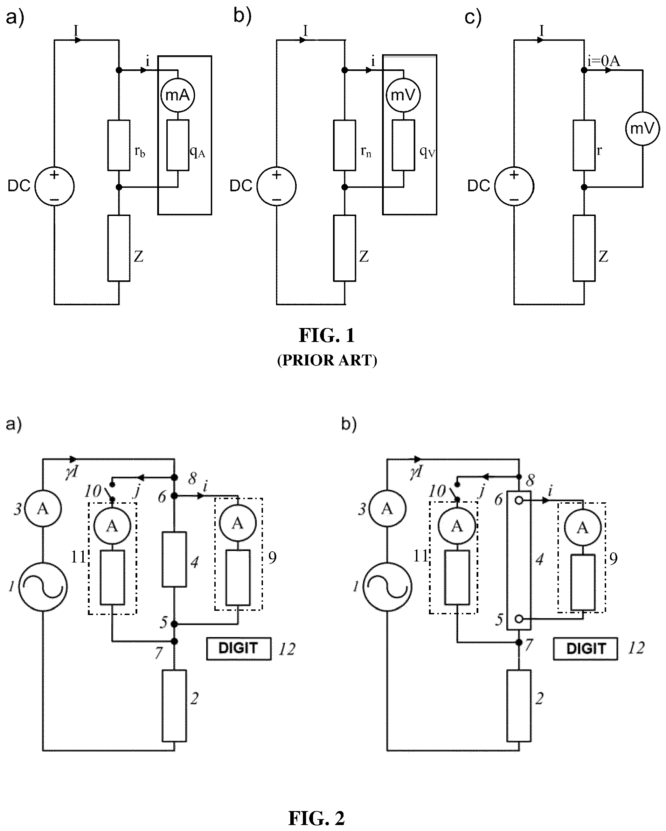

For a better understanding of the essence of the invention, **FIG 1** shows an electrical diagram of a prior-art measurement system in three variants: variant a) measuring current by means of a milliammeter with internal impedance $q_A$, variant b) measuring voltage by means of a millivoltmeter with internal impedance $q_v$, and variant c) measuring voltage by means of millivoltmeter with infinite internal impedance.

In the presented prior-art example, the measurement of direct technological current I in the aluminum electrolysis process is typically performed by a shunt having very large dimensions and weight and complex structure comprising many rods connected in parallel and made of a unique metal alloy (for example, manganin). Current of several hundred kA flows through the shunt having very large dimensions and weight. This current is supplied by means of rigid rails having large dimensions; that is why the disassembly of such a shunt is extremely difficult and expensive. Technological current comprises many harmonics related to the effects occurring in electrolytic tanks. Precise measurement of these harmonics makes it possible to define the state of the electrolysis process.

The proposed measurement system according to the invention in the embodiment carried out, in this case aluminum electrolysis process, consists in replacing the measurement instrument connected to the voltage terminals of the existing shunt $r_b$ in variant a) in **FIG. 1** measuring current with a milliammeter having internal impedance $q_A$, or a normal resistor $r_n$ in variant b) in **FIG. 1** measuring voltage with millivoltmeter having internal impedance $q_v$, with a digitally controlled milliammeter mA or millivoltmeter mV in variant a) or b), respectively, or a digital millivoltmeter having very high impedance treated as infinite internal impedance; as regards variant c) in **FIG. 1**, millivoltmeter mV is replaced. This assembly i.e. the shunt $r_b$ and digital milliammeter mA of **FIG. 1** in variant a) form a measurement system for the technological current I, in this case in the process of aluminum electrolysis, which is marked with reference number 3 in **FIG. 2** respectively in variant a) or b) showing a schematic diagram of the measurement system according to the invention. The parameters of this assembly are subject to the procedure of self-calibration and a second shunt having a simple structure is added thereto, which is connected in series to the path conducting the technological current I. In the presented case, it is a normal resistor or shunt 4 made not from many thin rods connected in parallel, but in the form of one thick bar with a conspicuous pair of current terminals (marked with reference numbers 7 and 8 in **FIG. 2**) for connecting the process current having the actual value $\gamma I$ and a pair of voltage terminals (marked with reference numbers 5 and 6 in **FIG. 2**). The digital measurement instrument marked with reference number 9 is connected in parallel to the said terminals 5 and 6, whereas to the said terminals 7 and 8 is connected the digital measurement instrument marked with reference number 11 with a digitally controlled switch 10 connected thereto in series. Both measurement instruments 9 and 11 are used in the self-calibration procedure.

**FIG. 2** illustrates a electrical diagram of the subject measurement system according to the invention in two embodiments, in variant a) with a normal resistor, in the embodiment presented it is a four-terminal resistor, and in variant b) with a shunt, wherein the measurement system according to the invention is characterized by a changing structure. Namely, the claimed measurement system according to the invention is divided into two digital circuits connected in series and measuring the same technological current *I*.

The electrical circuit under consideration comprises the first part of the circuit comprising the following connected in series: an electrical energy source 1, an electrical energy receiver 2 and a measurement instrument 3 subject to the procedure of self-calibration, and a second part of the circuit performing the self-calibration function described in detail below. The said first part of the circuit has a conventional structure and operates continuously. In this case the measurement instrument 3 is subject to self-calibration i.e. is subject to the procedure of self-calibration by determining the measurement properties, in the presented case, the value of coefficient $\gamma$, which corrects the results of the measurement instrument 3 for the technological current *I*.

The second part of the circuit in the presented case constitutes a calibration circuit designed to verify and periodically determine the measurement properties, in the presented case, to determine the values of coefficient $\gamma$ of the first part of the circuit in its real operating conditions. The said calibration circuit is connected in series into the flow path of current $\gamma I$ and comprises subassemblies marked with reference numbers 4, 9 and 11, and 10, and forms a parallel connection of three branches: the first branch comprising the measurement instrument 9 of auxiliary current *i*, and the second branch in the form of a normal resistor or a shunt 4, using a pair of voltage terminals 5 and 6, and the third branch, using a pair of current terminals 7 and 8, and comprising the switch 10 connected in series to the measurement instrument 11 of reference current *j*. The said switch 10 is digitally controlled by means of a digital synchronization and control system 12 designed to operate the measurement instruments 9, 11 of the calibration circuit and at the same time serving as an interface for the operator.

The calibration circuit (i.e. the second measurement system) is digitally controlled by means of the digital synchronization and control system 12, and measures the same technological current $\gamma I$, which allows the self-calibration procedure of the first measurement system to be performed without disrupting the current measurement by the first measurement system. The purpose of the operation of the said procedure of self-calibration, for each detected frequency in the recorded current waveforms, is to accurately determine the metrological parameters of the first measurement system, that is coefficient $\gamma$ defined as a complex number individually for each detected frequency of the correcting result of the measurement for the selected frequency component from the full spectrum of the technological current having a value *I* given by the measurement instrument 3 for given environmental conditions and in the current time, by means of the following relation:

$$\gamma = \frac{ji_1}{I_2 i_1 - I_1 i_2}$$

where:

$I_1$ - is the value of technological current measured by the measurement instrument 3 in the open state of switch 10,

$I_2$ - is the value of technological current measured by the measurement instrument 3 in the closed state of switch 10,

$i_1$ - is the value of auxiliary current measured by the measurement instrument 9 in the open state of switch 10,

$i_2$ - is the value of auxiliary current measured by the measurement instrument 9 in the closed state of switch 10,

$j$ - is the value of reference current measured by the measurement instrument 11 in the closed state of switch 10.

In the presented case, the measurement instrument identified by reference number 3 is a meter of the technological current having a high value actual value $\gamma I$ whereas this meter gives the value *I*, and in turn the measurement instrument marked with reference number 9 is a meter of the small auxiliary current *i*, whereas the measurement instrument marked with reference number 11 is a meter of also small reference current *j*. The current meter marked with reference numbers 9 and 11 is a digital milliammeter.

In the above relation, current values are treated as complex numbers individually for each harmonic and their values are obtained as a result of Fourier analysis of the measurement based on the instantaneous samples of values of these currents. The said second part of the circuit in the form of the calibration circuit cyclically (for example, with the interval of 1s) changes its structure by closing or opening the switch 10, thus performing self-calibration of the main measurement path (i.e. the first measurement system) for high value currents. Self-calibration is performed using the measurement instruments 9, 11, wherein only the measurement instrument 11 must be verified in a GUM laboratory as a milliammeter. On the other hand, the measuring instrument 9 is a meter that should have the autozeroing function enabled and should have a linear processing characteristics that can be verified at the place of operation, using the meter 11.

In another embodiment, a series system NI 9237 presented on the website https://www.ni.com/docs/en-US/bundle/ni-9237-getting-started/page/overview.html can be applied, and which can be directly used to carry out the calibration circuit for measuring the small currents, marked with 9 and 11 in **FIG. 2.** It only requires connecting normal reference resistors for small currents (in the order of single amperes) with a wide frequency spectrum and a reference voltage source that is verified for a wide frequency spectrum. This measurement standard is maintained under stable environmental conditions. Its operating temperature is maintained for the values in the order of 80°C, and thereby the measurement standard is resistant to the influence of temperature at sunny days. A highly stable reference voltage source, made using a thermally stabilized Zener diode, can be used as a reference for the measurements of electrical quantities. A 24-bit AD converter sampling with the frequency of 50 kHz is used to convert analogue quantities into their digital representation. The operation of the measurement standard is managed by a digital unit located therein, which simultaneously communicates with the master controller of the system, to which it transmits the values of the recorded signal samples at predetermined time intervals. In order to complete the entire system carrying out the self-calibration function, it is necessary to add the digitally controlled switch 10.

What is non-obvious in this case is that, for the components of the measured current of different frequencies, a different measurement constant is obtained for each of them as a result of self-calibration, which fact has been used in the solution according to the invention. The system's master controller performs the harmonic analysis of the obtained samples and extracts the detected frequency harmonics. For each of them, it performs an individual calibration of the first measurement system. For each detected frequency, a measurement constant is determined, which may and should differ from the values determined for other frequencies. It should be emphasized that the determination of correction coefficients $\gamma$ for all detected frequencies is carried out simultaneously. Moreover, a shunt (normal resistor) with double voltage terminals has been used. It is an element of the second measurement system, described above.

The above-mentioned digital synchronization and control system 12 in the presented case is equipped with a stable frequency reference, for example a cesium source, the size of a sugar cube, or is synchronized to a time reference provided by GPS. The digital synchronization and control system 12 performs the following tasks. It synchronizes all subassemblies of the measurement system with each other. It collects raw sampling results provided by the measurement instruments 3 for the high value current and 9 also 11 for the small currents. It changes the structure of the second measurement system by connecting and disconnecting the switch 10, it periodically determines the correct value of measured current (i.e. instantaneous values and the full spectrum (of harmonics)). In this way, coefficients are determined which correct the results of measurement (for each harmonic) performed by the first measurement system, in the same time interval in which the procedure of self-calibration operates. It provides the results of self-calibration, i.e. the identified correction coefficients of the technological current *I* meters, and provides the end user with the instantaneous values of the measured currents. It supervises the procedure of replacing the measurement instruments 9 and 11 for small currents. It stores the obtained results in its own memory, in case communication with the end user is lost. It performs periodic self-diagnosis. Based on the trend of changes in the identified coefficients of the measurement system, it determines the probability of damage to the measurement system itself as well as abnormal states of the technological process. The physical location of the digital synchronization and control system 12 (the processor with peripherals, implementing the control algorithm) is irrelevant to the operation of the entire measurement system. It is recommended to use fibre optic links for communication and data exchange.

Based on the assumption that the parameters of the entire measurement system change very slowly in relation to changes in the parameters of the measured signal, it is assumed that the obtained correction coefficients do not change during the period of inactivity of the procedure of self-calibration.

The above description of presented embodiments has been provided in order to enable any person skilled in the art to perform or use the invention. Various modifications of the presented embodiment are also possible, comprising all such changes, modifications and variants that fall within essence and scope of the appended claims. The basic principles set out herein may therefore be applied in other embodiments without going beyond the scope of the invention. Thus, the present invention is not intended to be limited to the embodiments presented herein but to accord with the widest scope consistent with the principles and novel features set out herein.

The present solution according to the invention thus offers, with the use of the above mentioned technical means, as indicated in the description and Figures, a measurement system for measuring high value currents with a wide frequency spectrum with the functionality of self-calibration in the actual operating conditions, in particular measuring current intensity by means of an adaptive shunt circuit with computationally corrected frequency characteristics, using methods for the self-calibration of the measurement path, and a method of such measurement.

## APPLICATION OF THE INVENTION

The invention can be widely applied in the electrical and electronics industry, in power grids for use in electric power equipment. In other words, the developed measurement system will generally find application wherever measurement of high value currents with a wide spectrum of frequencies is required to enable precise monitoring and management of systems, mainly control systems in the industrial sector for the safe and effective management of electrical energy, with particular focus on real-time systems.

The solution according to the invention can, for example, be used when measuring high value technological currents in the process of aluminum electrolysis, measuring fast-changing currents in arc furnaces, magnetic bearings, power grid current recording systems, i.e. analyzers, active filters. The solution can further be applied in reactive power compensation systems, electrical power systems, high-frequency inverters, electric drive control systems, and in electric traction.

Non-obvious also may be the use of the invention to detect microcracks in the rails or structural ropes of suspension bridges by continuously measuring their electrical parameters, which depend on the crystal structure of the material from which they are made.

**LIST OF REFERENCE**

**- MEASUREMENT SYSTEM FROM THE PRIOR ART -**

| | |
|---|---|
| Z | equivalent impedance of all electrolyzers |
| DC | source of technological direct current of electrolysis |
| I | technological current of electrolysis measured by a conventional measurement system |
| $r_b$ | shunt with resistance $r_b$ for measuring current I |
| $r, r_n$ | normal resistor with resistance $r_n$, r for measuring current I |
| $q_A$ | milliammeter internal resistance |
| $q_v$ | millivoltmeter internal resistance |
| mV | digital millivoltmeter calibrated in kA, indicating value I |
| mA | digital milliammeter calibrated in kA, indicating value I |
| i | current is circuit mV or mA |

**- MEASUREMENT SYSTEM ACCORDING TO THE INVENTION -**

| | |
|---|---|
| 1 | electrical energy source |
| 2 | electrical energy receiver |
| 3 | measurement instrument in the form of a technological current *I* meter in accordance with the prior-art |
| 4 | normal resistor or a shunt |
| 5, 6 | voltage terminals of a normal resistor or a shunt |
| 7, 8 | current terminals of a normal resistor or a shunt |
| 9 | measurement instrument in the form of an auxiliary current *i* meter |
| 10 | switch |
| 11 | measurement instrument in the form of a reference current j meter |
| 12 | digital synchronization and control system |

**Claims**

1. A measurement system for measuring high value currents with a wide frequency spectrum under real operating conditions comprises an electrical energy source (1) in the form of a DC or AC voltage source connected in series to a measurement instrument (3) designed to measure the correct or accurate value of a selected frequency component of current $\gamma I$ in the circuit of an electrical energy receiver (2), wherein the measurement instrument (3), indicating an inaccurate value *I*, is subject to the process of self-calibration, **characterized in that**
it has a built-in calibration circuit connected in series to the flow path of current $\gamma I$, which the calibration circuit is designed to verify and periodically determine the measurement properties of the measurement instrument (3), that is coefficient $\gamma$, at the place and time of operation of the measurement instrument (3), comprises a parallel connection of three branches: the first branch comprising a measurement instrument (9) of auxiliary current i and the second branch in the form of a normal resistor or a shunt (4) using a pair of voltage terminals (5) and (6), and also the third branch, using a pair of current terminals (7) and (8) of the shunt and comprising a switch (10) connected in series to a measurement instrument (11) of reference current *j*, wherein the individual subassemblies of the calibration circuit are integrated with one another and are digitally controlled by means of a digital synchronization and control system (12) which simultaneously constitutes an interface for the operator.

2. The measurement system according to claim 1, **characterized in that** the measurement instrument (3) or the measurement instrument (9) of the first branch or the normal resistor together with the shunt (4) of the second branch is made using a current transformer, a current transducer or a Rogowski coil.

3. A method for measuring, using the measurement system of claim 1, high value currents with a wide frequency spectrum under real operating conditions, comprising measuring the correct or accurate value of a selected frequency component of current $\gamma I$ in the circuit of the electrical energy receiver (2) by means of the measurement instrument (3) while the measurement instrument (3) gives an inaccurate value *I*, wherein
the measurement instrument (3) is subjected to the process of self-calibration for each detected frequency in the recorded current waveforms by determining the value of coefficient $\gamma$ defined as a complex number individually for each detected frequency of the correcting results of the measurement of the frequency component from the full spectrum of technological current *I* supplied by the measurement instrument (3) using the calibration circuit connected in series to the flow path of current $\gamma I$, by means of the following relation:

$$\gamma = \frac{j i_1}{I_2 i_1 - I_1 i_2}$$

where:

$I_1$ - is the value of technological current measured by the measurement instrument (3) in the open state of the switch (10),

$I_2$ - is the value of technological current measured by the measurement instrument (3) in the closed state of the switch (10),

$i_1$ - is the value of auxiliary current measured by the measurement instrument (9) in the open state of the switch (10),

$i_2$ - is the value of auxiliary current measured by the measurement instrument (9) in the closed state of the switch (10),

$j$ - is the value of reference current measured by the measurement instrument (11) in the closed state of the switch (10).

wherein the calibration circuit changes its structure cyclically by closing and opening the switch (10) digitally controlled by means of the digital synchronization and control system (12).

4. The measurement method according to claim 3, **characterized in that** the calibration circuit changes its structure cyclically, preferably with the period of 1s.

## Patentansprüche

1. Ein Messsystem zur Messung hoher Ströme mit breitem Frequenzspektrum unter realen Betriebsbedingungen, das eine elektrische Energiequelle (1) in Form einer Gleich- oder Wechselspannungsquelle umfasst, die in Reihe mit einem Messgerät (3) geschaltet ist, das zur Messung des korrekten und genauen Werts einer ausgewählten Frequenzkomponente des Stroms $\gamma I$ im Stromkreis eines elektrischen Energieempfängers (2) dient, wobei das Messgerät (3) bei Anzeige eines ungenauen I-Wertes eine Selbstkalibrierung durchführt, und das System **dadurch gekennzeichnet ist, dass** es über eine integrierte Kalibrierschaltung verfügt, die in Reihe mit dem Strompfad $\gamma I$ geschaltet ist, wobei diese Kalibrierschaltung der Überprüfung und periodischen Bestimmung der Messeigenschaften des Messgeräts (3), d. h. des Koeffizienten $\gamma$, am jeweiligen Betriebsort und -Zeitpunkt des Messgeräts (3), dient, und die Kalibrierschaltung aus drei parallelgeschalteten Zweigen besteht: einem ersten Zweig mit dem Hilfsstrom $i$ des Messgeräts (9), einem zweiten Zweig in Form eines normalen Widerstands oder eines Nebenwiderstandes (4) mit zwei Spannungsanschlüssen (5) und (6) sowie einem dritten Zweig der zwei Stromanschlüssen (7) und (8) des Nebenwiderstandes hat, und einen Umschalter (10) umfasst, der in Reihe mit einem Messgerät (11) für Referenzstrom j geschaltet ist, wobei die einzelnen Baugruppen des Kalibrierschaltung miteinander integriert sind und digital mittels eines digitalen Synchronisations- und Steuerungssystems (12) gesteuert werden, das gleichzeitig eine Schnittstelle für den Bediener bildet.

2. Messsystem nach Anspruch 1 **dadurch gekennzeichnet, dass** das Messgerät (3) oder das Messgerät (9) des ersten Zweigs oder der Normalwiderstand zusammen mit dem Nebenwiderstand (4) des zweiten Zweigs mittels eines Stromwandlers, eines Stromaufnehmers oder einer Rogowski-Spule gebildet wird.

3. Verfahren zur Hochstrommessung mit breitem Frequenzspektrum unter realen Betriebsbedingungen mithilfe vom Messsystems nach Anspruch 1, das die Messung des korrekten oder genauen Werts einer ausgewählten Frequenzkomponente des Stroms $\gamma I$ im Stromkreis des elektrischen Energieempfängers (2) mittels des Messgeräts (3), während das Messgerät (3) einen ungenauen Wert $I$ liefert, wobei das Messgerät (3) für jede erfasste Frequenz in den aufgezeichneten Stromverläufen durch Bestimmung von Wert des definierten als eine komplexe Zahl $\gamma$-Koeffizienten (der einzeln für jede erfasste Frequenz der Korrekturergebnisse der Messung der Frequenzkomponente aus dem Vollspektrum des technologischen Stroms $I$ mit dem Messgerät (3) unter Verwendung der in Reihe mit dem Strompfad $\gamma I$ geschalteten Kalibrierschaltung ermittelt wird), der Selbstkalibrierung unterzogen wird - mittels der folgenden Beziehung:

$$\gamma = \frac{j i_1}{I_2 i_1 - I_1 i_2}$$

wobei:

$I_1$ - der vom Messgerät (3) im geöffneten Zustand des Umschalters (10) gemessene Wert des technologischen Stroms ist.

$I_2$ - der vom Messgerät (3) im geschlossenen Zustand des Umschalters (10) gemessene Wert des technologischen Stroms ist,

$i_1$ - der vom Messgerät (9) im offenen Zustand des Umschalters (10) gemessene Wert des Hilfsstroms ist,

$i_2$ - der vom Messgerät (9) im geschlossenen Zustand des Umschalters (10) gemessene Wert des Hilfsstroms ist,

$j$ - der vom Messgerät (11) im geschlossenen Zustand des Umschalters (10) gemessene Wert des Referenzstroms ist.

dabei die Kalibrierschaltung seine Struktur zyklisch durch Schließen und Öffnen des Umschalters (10) ändert, der digital mittels des digitalen Synchronisations- und Steuerungssystems (12) gesteuert wird.

4. Messverfahren nach Anspruch 3 **dadurch gekennzeichnet, dass** der Kalibrierschaltung seine Struktur zyklisch, vorzugsweise mit einer Periode von 1 s, ändert.

## Revendications

1. Un système de mesure de courants de forte amplitude sur un large spectre de fréquences, en conditions réelles d'utilisation, comprend une source d'énergie électrique (1), sous forme de source de tension constante ou alternative, connectée en série à un instrument de mesure (3) conçu pour mesurer la valeur exacte d'une composante fréquentielle sélectionnée du courant $\gamma I$ dans le circuit d'un récepteur d'énergie électrique (2) et l'instrument de mesure (3), lorsqu'il indique une valeur inexacte $I$, est soumis à un processus d'auto-étalonnage, et le système est **caractérisé en ce qu'**il possède un circuit d'étalonnage intégré, connecté en série au trajet du courant $\gamma I$, et ce circuit d'étalonnage est conçu pour vérifier et déterminer périodiquement les propriétés de mesure de l'instrument (3), notamment le coefficient $\gamma$, au lieu et au moment de fonctionnement de mesure de l'instrument (3), et le système comprend une connexion parallèle de trois branches: la première branche comprend un instrument de mesure (9) du courant auxiliaire $i$; la deuxième branche est constituée d'un résistor ou d'une dérivation (4) utilisant une paire de bornes de tension (5) et (6); et la troisième branche utilise une paire de bornes de courant (7) et (8) de la dérivation, et comprend un commutateur (10) connecté en série à un instrument de mesure (11) du courant de référence $j$ dans lequel les différents sous-ensembles du circuit d'étalonnage sont intégrés entre eux et commandés numériquement par un système de synchronisation et de commande numérique (12) qui constitue simultanément une interface pour l'opérateur.

2. Système de mesure selon la revendication 1 **caractérisé en ce que** l'instrument de mesure (3) ou l'instrument de mesure (9) de la première branche, ou la résistance normale associée à la dérivation (4) de la seconde branche, est réalisé à l'aide d'un transformateur de courant, d'un transducteur de courant ou d'une bobine de Rogowski.

3. Procédé de mesure, utilisant le système de mesure selon la revendication 1, de courants de forte amplitude à large spectre de fréquences en conditions réelles de fonctionnement, comprenant la mesure de la valeur correcte ou précise d'une composante fréquentielle sélectionnée du courant $\gamma I$ dans le circuit du récepteur d'énergie électrique (2) au moyen de l'instrument de mesure (3), alors que l'instrument de mesure (3) fournit une valeur inexacte $I$, dans lequel

l'instrument de mesure (3) est soumis à un processus d'auto-étalonnage pour chaque fréquence détectée dans les formes d'onde de courant enregistrées et cet étalonnage consiste à déterminer la valeur du coefficient $\gamma$, défini individuellement pour chaque fréquence détectée, à partir des résultats de correction de la mesure de la composante fréquentielle du courant technologique $I$ fourni par l'instrument de mesure (3), ce coefficient étant calculé à l'aide du circuit d'étalonnage connecté en série avec le circuit de courant $\gamma I$, selon la relation suivante:

$$\gamma = \frac{j i_1}{I_2 i_1 - I_1 i_2}$$

où:

$I_1$ - représente la valeur du courant technologique mesurée par l'instrument de mesure (3) lorsque le commutateur (10) est ouvert.

$I_2$ - représente la valeur du courant technologique mesurée par l'instrument de mesure (3) lorsque le commutateur (10) est fermé.

$i_1$ - représente la valeur du courant auxiliaire mesurée par l'instrument de mesure (9) lorsque le commutateur (10) est ouvert.

$i_2$ - représente la valeur du courant auxiliaire mesurée par l'instrument de mesure (9) lorsque le commutateur (10) est fermé.

$j$ - représente la valeur du courant de référence mesurée par l'instrument de mesure (11) lorsque le commutateur (10) est fermé.

dans lequel le circuit d'étalonnage modifie sa structure de manière cyclique par l'ouverture et la fermeture du commutateur (10), qui est commandé numériquement par le système de synchronisation et de commande numérique (12).

4. Procédé de mesure selon la revendication 3 **caractérisé en ce que** le circuit d'étalonnage modifie sa structure de manière cyclique, de préférence avec une période de 1 s.

a)

b)

c)

**FIG. 1**
**(PRIOR ART)**

a)

b)

**FIG. 2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2022413017 A